(19) Europäisches Patentamt / European Patent Office / Office européen des brevets

(11) **EP 1 271 580 B1**

## (12) EUROPEAN PATENT SPECIFICATION

(45) Date of publication and mention
of the grant of the patent:
**03.07.2013 Bulletin 2013/27**

(51) Int Cl.:
*H01L 51/42* (2006.01)   *B82Y 30/00* (2011.01)

(21) Application number: **01430019.8**

(22) Date of filing: **29.06.2001**

(54) **A photo-electrochemical cell of improved photon conversion efficiency**

Photoelektrochemische Zelle mit verbessertem Wirkungsgrad

Celulle photoelectrochimique à rendement amélioré

(84) Designated Contracting States:
**DE FR**

(43) Date of publication of application:
**02.01.2003 Bulletin 2003/01**

(73) Proprietor: **IMRA EUROPE S.A.**
**F-06560 Valbonne (FR)**

(72) Inventors:
• **Chone, Christophe,**
**Résidence l'Orangerie Bât B**
**06100 Nice (FR)**
• **Larramona, Gerardo**
**06560 Valbonne (FR)**
• **Sakakura, Daisuke**
**06600 Antibes (FR)**

(74) Representative: **Domange, Maxime et al**
**Cabinet Beau de Lomenie**
**232, avenue du Prado**
**13295 Marseille Cedex 08 (FR)**

(56) References cited:
**EP-A- 1 089 305     US-B1- 6 252 156**

• **PATENT ABSTRACTS OF JAPAN vol. 2000, no. 07, 29 September 2000 (2000-09-29) & JP 2000 106222 A (FUJI PHOTO FILM CO LTD), 11 April 2000 (2000-04-11)**
• **USAMI A: "Theoretical study of application of multiple scattering of light to a dye-sensitized nanocrystalline photoelectrochemical cell" CHEMICAL PHYSICS LETTERS, 3 OCT. 1997, ELSEVIER, NETHERLANDS, vol. 277, no. 1-3, pages 105-108, XP001041386 ISSN: 0009-2614**
• **MORITZ T ET AL: "Characterization of thin ceramic layers with a graded pore structure" 5TH INTERNATIONAL SYMPOSIUM ON FUNCTIONALLY GRADED MATERIALS, DRESDEN, GERMANY, 26-29 OCT. 1998, vol. 308-311, pages 884-889, XP001034773 Materials Science Forum, 1999, Trans Tech Publications, Switzerland ISSN: 0255-5476**
• **ROTHENBERGER G ET AL: "A contribution to the optical design of dye-sensitized nanocrystalline solar cells" SOLAR ENERGY MATERIALS AND SOLAR CELLS, ELSEVIER SCIENCE PUBLISHERS, AMSTERDAM, NL, vol. 58, no. 3, 15 July 1999 (1999-07-15), pages 321-336, XP004179801 ISSN: 0927-0248**
• **BARBE C J ET AL: "nanocrystalline titanium oxide electrodes for photovoltaic applications" JOURNAL OF THE AMERICAN CERAMIC SOCIETY, AMERICAN CERAMIC SOCIETY. COLUMBUS, US, vol. 80, no. 12, 1997, pages 3157-3171, XP002178698 ISSN: 0002-7820**

**Description**

This invention concerns a photo-electrochemical cell, in particular the improvement of the photo-anode, that is, the electrode receiving incident light and converting this light into electricity. More particularly, the present invention relates to a photo-electrochemical cell, comprising an anode electrode having a film of metal oxide semiconductor particles which have been deposited and sintered on a transparent conductive substrate, a dye that is adsorbed as a monomolecular layer on the surface of said metal oxide particles, a cathode electrode, and an electrolyte that is filling the space between the said anode electrode and cathode electrode.

Such a kind of cell is well known and described in the U.S. Patent 5,084,365 (1992) by Graetzel et al. The sensitivity, i.e., the photo-electrochemical yield for visible light, is increased by chromophores, also known as sensitizers or dyes, deposited as a monomolecular chromophore layer on the surface of a semiconductor. Other prior art documents comprise EP 1 089 305 and an article by Rothenberger et al. in Solar Energy Materials and Solar Cells 58 (1999) 321-336.

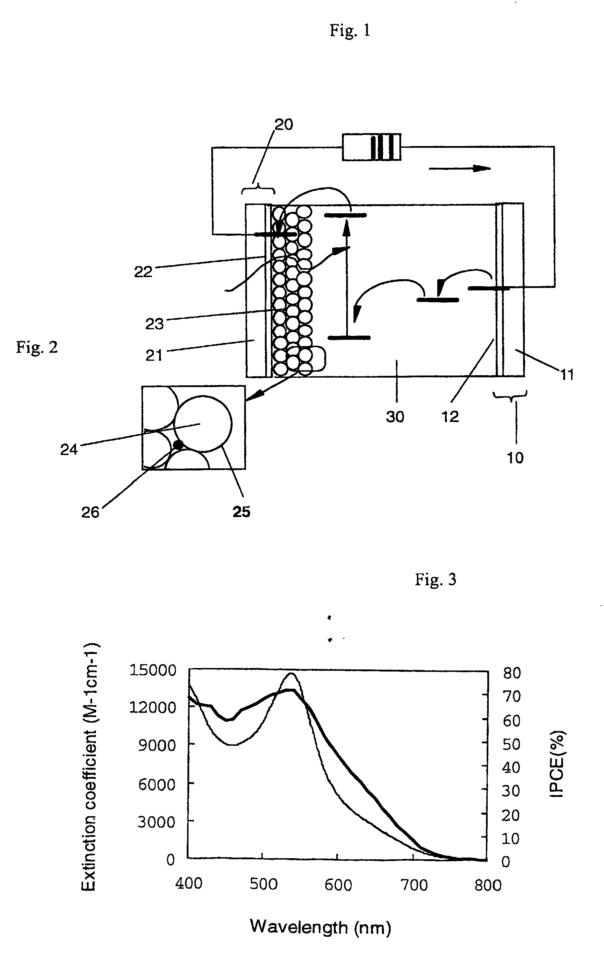

Figure 1 and Figure 2 explain this type of photo-electrochemical cell of the present invention. Figure 1 shows the schematic explaining the structure and the principle of a photo-electrochemical cell. Figure 2 shows an enlarged schematic describing the structure of metal oxide film (which has a semiconductor character) and the dye adsorbed on that film.

The photo-electrochemical cell consists of a cathode electrode 10, an anode electrode 20 that is at opposite side of this cathode electrode 10, and an electrolyte 30. The cathode electrode 10 consists of a glass piece 11 and a transparent conductive layer 12, which is deposited on the glass 11. The transparent conductive layer 12 can be, for example, a fluorine-doped $SnO_2$ thin film on which Pt is deposited as a catalyst.

The electrolyte 30 consists of a redox couple, preferentially the iodide/tri-iodide couple ($I^-/I_3^-$), which is dissolved in an organic solvent like, for example, acetonitrile.

The photo-anode electrode 20 consists of a conductive transparent layer 22 which can be for example, a fluorine-doped $SnO_2$ thin film deposited on a glass piece 21, and the film 23 made with a porous metal oxide semiconductor layer that is deposited on the transparent conductive layer 22. The semiconductor layer 23 is prepared with metal oxide crystal particles which were sintered by heating. The ensemble of the conductive transparent layer 22 and the glass piece 21 is called the substrate of the anode electrode.

Moreover, as shown in Figure 2, this semiconductor layer 23 is sensitised by adsorbing a dye 25 composed preferentially by a ruthenium complex comprising more particularly cis-di(thiocyanato)bis(4,4'-dicarboxylate-2,2'-bipyridine) ruthenium(II), on the surface of the metal oxide crystal particles 24. The semiconductor layer 23 sensitised with the adsorbed dye 25 is called the active part of the anode electrode.

The electrolyte 30 is filling the space between the cathode electrode 10 and the anode electrode 20, as well as the pores 26 between the metal oxide crystal particles 24.

The operation principle of the above-mentioned photo-electrochemical cell is shown in Figure 1. When the light, for example, the sunlight, penetrates through the glass piece substrate 21 and the transparent conductive layer 22 of the anode electrode 20, it reaches the film 23 composed by the semiconductor layer, and it is absorbed by dye 25 adsorbed on the surface of the metal oxide semiconductor crystal particles 24. Consequently, the dye is excited. As the energy level of dye excited state is higher (more negative redox potential) than the conduction band level of the metal oxide ($TiO_2$), the dye excited state injects an electron into the metal oxide. Following this electron injection, the dye 25 is now oxidized. The electrons injected into the metal oxide move through the metal oxide film 23 and reach the transparent conductive layer 22. Then, the electrons reach the cathode electrode passing through the external circuit. In the cathode electrode, the reduction reaction of the redox couple is produced at the interface between the Pt catalyst deposited on the transparent conductive layer 12 and the electrolyte 30. In that sense, the electrons reaching the cathode electrode 10 react with the $I_3^-$ species in the electrolyte 30 and produced $I^-$. The $I^-$ species, which received electrons in the cathode electrode, move in the electrolyte 30, which is filling the pores 26 between the metal oxide crystal particles 24, and reduce the dye 25 which was in oxidized state. The cycle of the photo-electrochemical cell is then completed. In this way, the photo-electrochemical cell is able to convert light energy such as sunlight into electrical energy.

Also, in the above-mentioned photo-electrochemical cell, it is possible to increase the dye adsorption surface area more than 150 times the projected area by decreasing the size of the metal oxide particles. This means that this photo-electrochemical cell is able to adsorb more dye molecules on metal oxide particles than a photo-electrochemical cell composed of other materials such as a single crystal metal oxide semiconductor, and, as a result, a relatively high photon-to-electron conversion can be obtained by effective incident light absorption.

In US 5,084,365, a surface having a roughness factor of more than 20 and preferably more than 150, for example, about 200, is preferred. The roughness is defined as the ratio of an actual/effective surface of the projected area of that surface of a body, i.e., in the present case, the photo-electrochemically active surface of the metal oxide semiconductor.

The rough surface of the metal oxide with a polycrystalline structure offers an area greater by the roughness factor for a monomolecular surface layer of the chromophore. Consequently, the light incident on an area of a specific size is converted to electrical energy with a considerably greater yield.

In the existing technology, the TiO$_2$ particles sizes was conventionally within 10-25 nm and the BET surface of the metal oxide layer was about 100 m$^2$/g.

According to the theoretical analysis on this type of photo-electrochemical cell using a single dye and TiO2 as the metal oxide semiconductor on the photo-anode, it is known that the maximum power conversion efficiency can be obtained when the incident light of wavelengths between 400nm and 900~1000nm is totally absorbed and converted into electrical energy.

The present situation is that the photon conversion efficiency has been still low because the incident light could not be used efficiently. For example, even though the dye cis-di(thiocyanato)bis(4,4'-dicarboxylate-2,2'-bipyridine)ruthenium(II) is known as the dye having one of the best performance in the present technology for such a photo-electrochemical cell, an effective photon conversion efficiency in the long wavelength range over 600 nm could not be obtained, as shown in Figure 3.

As shown in Figure 3, the incident photon conversion efficiency (IPCE) as a function of the wavelength is almost linked to the light absorption coefficient of the dye used in this photo-electrochemical cell. Therefore, one of the methods to improve photon conversion efficiency consists in replacing the dye with another dye that has an improved light absorption coefficient for the wavelength range of 600-1000nm. However, this type of dye is not available in the present technology.

Another method investigated by the inventors to improve photon conversion efficiency was, for example, the improvement of the low light absorption coefficient of the dye molecule in the long wavelength range by thickening the metal oxide semiconductor film which will enlarge the dye adsorption surface area. However, this causes a new problem which is the increased risk of having cracks on the thick film during the sintering process. Furthermore, the diffusion flow of the redox couple, which carries the charge and diffuse through the electrolyte filling the space between the metal oxide crystal particles, will be slowed down and the current density will be lowered, consequently the photon conversion efficiency will be deteriorated.

Also, the thickening of the film can have an effect on the open-circuit voltage of this photo-electrochemical cell, which can be described concretely by following formula.

$$ \text{Voc} = \frac{\text{mkT}}{\text{e}} \ln\left(\frac{I_{ph}}{I_o}\right) $$

m: Ideal factor, k: Boltzmann constant, T: Absolute temperature, e: charge of electron,
$I_{ph}$: Photo-current obtained by this photo-electrochemical cell, Io: Dark current that is produced by recombination of electron injected into the metal oxide and the redox couple in the electrolyte

The recombination probability of the electron injected into the metal oxide and the redox couple in the electrolyte is increased by increasing the film thickness; consequently, the dark current Io will be increased and the voltage Voc will be decreased.

A further method investigated by the inventors was to improve photon conversion efficiency by controlling the metal oxide particle diameter at 300-500nm in order to improve the light scattering effect. In the light scattering theory it is known that the light can be scattered most efficiently when the particle diameter is half of the wavelength. From this point of view, it could be preferable to have a metal oxide particle size of 300-500nm in order to obtain the most effective light scattering in the metal oxide film illuminated with incident light of wavelengths 600-1000nm, so the photo conversion efficiency has to be improved. However, it is hard to improve the photon conversion efficiency by this method, likely because the total surface area of metal oxide particles is decreased, which means that the dye adsorption area is decreased. Moreover, a higher temperature for the sintering of the metal oxide particles to form a film is requested because of the bigger particle size. By considering the fusing point of glass used in the anode electrode, a low temperature is preferable for the metal oxide sintering of the film.

Therefore, this invention aims to improve the photon conversion efficiency in such a photo-electrochemical cell, in particular the technical issue which improves the photon conversion efficiency in longer wavelength range by the improvement of the photo-electrode (anode electrode).

The proposed solution provided by this invention to solve the above-mentioned problems is that the metal oxide semiconductor film used for the anode electrode of the photo-electrochemical cell is prepared with metal oxide particles of different sizes, ranging from sizes at least smaller than 30 nm and sizes at least bigger than 100 nm, and, moreover, with the average particle size being 30-50 nm.

With this composition, the surface area for dye adsorption can be assured by the smaller sized particles and the light scattering effect can be improved by the bigger sized particles. In addition, the sintering of the metal oxide film can be done at low temperatures by means of the small sized metal oxide particles. However, this invention does not exclude the presence in the film of a mixture of different metal oxide particles sized between 30 nm and 100 nm.

According to the invention, the surface area for dye adsorption can be assured by the small size metal oxide particles and the light scattering effect can be improved by big size metal oxide particles, and, consequently, the photon conversion efficiency can be improved without degradation of voltage in the photo-electrochemical cell.

In addition, there is no more risk for cracking during sintering by including small size metal oxide particles and it is not necessary to set the temperature extremely high for the sintering thanks to the presence of the small particles.

Therefore, the present invention provides a photo-electrochemical cell, comprising an anode electrode having a film of metal oxide semiconductor particles which have been deposited and sintered on a transparent substrate, a dye that is adsorbed as a monomolecular layer on the surface of said metal oxide particles, a cathode electrode, and an electrolyte that is filling the space between the said anode electrode and cathode electrode, characterised in that the said metal oxide particle comprise :

- small size metal oxide particles of sizes less than 30 nm and preferably higher than 10 nm, and

- big size metal oxide particles of sizes bigger than 100 nm and preferably smaller than 200 nm, and

- the average particle size of the particle is 30-50 nm.

The proportions said of small particles of sizes lower than 30nm and said big particles of sizes higher than 100 nm are such that they allow to improve the photon conversion efficiency of the cell by keeping the dye absorption area and by improving the light scattering effect.

More particularly the proportions in weight of said small particles is at least 15 %, preferably at least 20 % more particularly within the range 20-30 % and the proportion of said big particles is at least 1 %, preferably at least 5 %, more particularly within the range 5-15 %.

In a preferred embodiment, the particles of the said metal oxide are particles of $TiO_2$, and more preferably the BET surface area of said metal oxide particles layer is from 25 to 45 $m^2$/g.

From their numerous comparative assays, the inventors have found that the following characteristics are advantageous :

- the distribution of particle size of said metal oxide particles is comprised in the range from 10 to 200 nm, and more particularly the distribution of the particle sizes of said metal oxide particles is comprised in the range from 15 to 180nm.

- the porosity of the said metal oxide layer is from 45 to 55 %. The porosity appears to enhance the light scattering effect and the electrolyte species diffusion through the metal oxide layer.

- The thickness of said metal oxide layer is from 10 to 25 $\mu$m.

Preferably the film on the anode electrode is a 2-layer structure, wherein the first layer is deposited directly on the anode electrode substrate and the second layer is deposited on the first layer. In particular, it is preferable that the second layer is more porous (less dense) than the first layer. In particular, it is preferable if the porosity of the first layer is between 45% and 55%, and the porosity of the second layer is between 55% and 65%. With this structured film, a larger surface area for dye adsorption can be obtained for the first layer compared with the surface area of the second layer, since the first layer is more dense than the second layer. In the first layer, which is close to the anode electrode substrate, the dye molecule is excited by the incident light and the injection of electrons into the conductive band of the metal oxide takes place more effectively than in the second layer.

Preferably the average metal oxide particle size of the said second layer is similar to the one of the said first layer. More particularly, the distribution of the metal oxide particle sizes of said second layer is comprised in the range from 10 to 200 nm with an average size from 30 to 50 nm.

Preferably, the thickness of said first layer is from 10 to 25 $\mu$m and the thickness of said second layer is from 5 to 20 $\mu$m.

The most important role of the second layer is to increase the light scattering effect both because of the presence of the bigger metal oxide particles, and also because of the presence of pores, which are present in higher amount and have a size which also produce light scattering. In addition, the increased amount of pores present in the second layer improves the diffusion flow of the redox couple and, consequently, the reduction of the dye (when oxidized by injecting electrons into the conductive band of the first layer) by the redox couple is speed up.

Suitable chromophores, i.e., sensitizers, are any kind of dyes such as complexes of transition metals for example complex of ruthenium and osmium and more particularly any kind of other type of organic or organometallic dyes. The chromophores may be chemisorbed, absorbed or otherwise by permanently added as a momomolecular layer in the region of the surface of the metal oxide semiconductor.

Examples of an electrolyte for such photoelectrochemical cells are iodide, bromide, hydroquinone or other redox systems. Because of their redox potential, these electrolytes act as pure relay substances for the charge transport.

Good conversion efficiency are obtained when the electrolyte comprises the redox couple $I^-/I_2$ dissolved in an organic solvent preferably acetonitrile and the dye comprises a ruthenium complex with ligand comprising preferably carboxylate groups.

Other advantages and characteristics of the present invention will be apparent from the following examples 1 and 2.

Fig.1 is the drawing that explains the structure and the principle of the photo-electrochemical cell. In figures the following references have the following meanings :

          10: Cathode electrode
          11: Glass
          12: Transparent conductive layer
          20: Anode electrode
          21: Glass
          22: Transparent conductive layer
          23: TiO2 layer (film)
          24: TiO2 particle
          25: Dye
          26: Pore between TiO2 particles
          30: Electrolyte

Fig.2 is the enlarged drawing of the part A in Fig 1.

Fig.3 is the graph contrasting the dye absorption coefficient (left graduations) and the photon conversion efficiency (IPCE %) of conventional photo-electrochemical cell (right graduations). When using metal oxide films of small particle size, the film does not appreciably scatter the light and the better IPCE which can be obtained follows the absorption spectrum of the sensitizer.

Fig.4 is the graph showing the photon conversion efficiency (IPCE %) of the first example of this invention and two comparative examples.

Fig.5 is the graph showing the photon conversion efficiencies (IPCE %) of the photo-electrochemical cells prepared in the example 1 and the example 2 of this invention.

Example 1

This is the explanation about the fabrication method of the anode electrode, in which TiO2 particles are produced by an autoclave method and the TiO2 film is deposited on the anode substrate and sintered. The particle size and particle size distribution of TiO2 prepared by an autoclave method can be changed by means of different parameters like the pH of the hydrothermal treatment or the temperature of the autoclave. The following explanations concern the synthesis of examples of TiO2 colloids that have the particle size distribution of this invention.

At room temperature, pour 125 mL of titanium isopropoxide (from Aldrich) by few drops at a time into 750 mL of an alkaline solution of 0.1M of alkali (e.g. tetramethylammonium hydroxide) while stirring strongly. The obtained slurry is stirred at 80°C for 8 hours. After this procedure, the isopropanol obtained in the reaction is removed by evaporation and about 700 mL of TiO2 sol is obtained. This sol is then placed in the autoclave at 260°C for 12 hours and, afterwards, it is left cooling down naturally. After adding Triton X-100 at 10% in total volume to the obtained TiO2 paste, it is deposited on a transparent conductive oxide (TCO) glass (having a resistance of 10Ω/square) by using a doctor blade method. After drying the film at room temperature, the obtained film is sintered at 450°C for 20 minutes, and, as a result, a porous TiO2 film with about 17 $\mu$m film thickness and the above-mentioned particle size distribution is obtained.

The following explanation concerns the example of the photo-electrochemical cell fabrication with the above-mentioned TiO2 film.

Soak the TiO2 film prepared by the above-mentioned method in a dry ethanol solution of $3 \cdot 10^{-4}$ M of the dye cis-di(dhiocyanato)bis(4.4'-dicarboxylate-2.2'-bipyridine)ruthenium(II) during 24 hours, as described in the article "J.Am.Chem.Soc, vol. 115 (1993), pags. 6382-6390". Then, the dye is deposited on the surface of the TiO2 film, and the electrode is taken out from the solution under a stream of Ar. The anode electrode of the photo-electrochemical cell has been fabricated.

This anode is then used to fabricate the photo-electrochemical cell whose structure is indicated in Fig.1, by the method described in the article "J.Am.Chem.Soc, vol. 115 (1993), pags. 6382-6390". An example of electrolyte that can be used is [I⁻]=0.7M and [I₂]=0.1 M dissolved in acetonitrile.

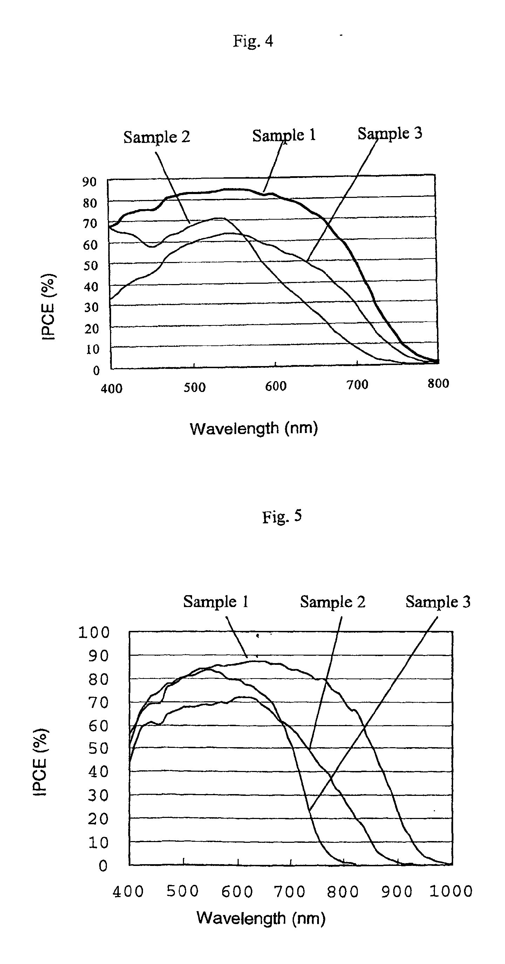

The photon conversion efficiency of the photo-electrochemical cell fabricated by the above procedure is indicated in the Fig. 4 together with other comparative examples. This graph of Fig 4 shows the photon conversion efficiency as a function of the wavelength of the photo-electrochemical solar cell of this invention (sample 1) and other comparative examples (sample 2 & 3). The specific surface of the polycristalline films are characterized with the well-know BET method based on adsorption on nitrogen. The average particle size was estimated by the spherical approximation, using the following formula:

$$d = 6000 / (BET \times \rho)$$

where d is the average particle diameter, expressed in [nm], BET is the BET surface expressed in $[m^2/g]$, and $\rho$ is the $TiO_2$ density which is equal to 3.84 g/cm³. The porosity of the film can be obtained with the same technique, from which the "pore volume" (expressed in $[cm^3/g]$) is calculated applying either the BET algorithm or the BJT algorithm. The "pore volume" is readily converted into the porosity coefficient $\epsilon_P$ (or just called porosity, expressed in % units), which is the proportion of the empty volume against the total geometric volume of the film.

The roughness factor of the film, G, can be easily calculated by taking into account the specific surface (here the BET surface), the porosity ($\epsilon_P$), and the film thickness (e), as shown in the following formula:

$$G = BET \times d \times e \times (1 - \epsilon_P)$$

where $\underline{d}$ is the $TiO_2$ density (3.84 g/cm³), $\underline{e}$ is the film thickness is expressed in $[\mu m]$, and $\underline{BET}$ is the BET surface in $[m^2/g]$.

The distribution of particle size can be done by taking pictures with Scanning Electron Microscopy (SEM). The weight proportions of narrower ranges of particle sizes can be done by selective sedimentation by centrifugation of the colloid used on the film fabrication, followed by the characterization of the narrower ranges of particle sizes using the BET technique.

The distribution of particle size and the BET average particle size for sample 1, 2, and 3 are shown in the following chart.

| Sample No | Distribution of particle size (nm) | BET average particle diameter size (nm) | BET Surface (m²/g) | Roughness factor |
|-----------|-----------------------------------|------------------------------------------|---------------------|------------------|
| Sample 1 | 15-180 | 46 | 30 | 1800 |
| Sample 2 | 8-15 | 10 | 90 | 2200 |
| Sample 3 | 60-200 | 92 | 10 | 1600 |

The sample 2 is fabricated by one method published in the article "J.Am.Chem.Soc, vol. 115 (1993), pags. 6382-6390" , which is similar to the one used for Sample 1 but choosing an acid pH (acid or nitric acid) and an autoclave temperature of about 230°C. Sample 3 was obtained by partial centrifugation of the colloid obtained for Sample 1. For all samples, the illuminated area of the photo-electrochemical cell was fixed to 0.54 cm2 (6mm x 9mm). The better results were obtained when the thickness of TiO2 film was between 12 and 17 $\mu$m.

As clearly shown in the graph of Fig 4, the photo-electrochemical cell of this invention (1) has remarkably high photon conversion efficiency, especially in the 600-900nm wavelength range, compared with those of sample (2) and sample (3) that are fabricated based on existing technologies.

Also, for the output voltage, the photo-electrochemical cell of this invention (1) shows 0.68V under the photovoltaic standard condition of AirMass1.5 and 1000 W/m2, which is approximately the same value of sample 2, that is 0.67V. Therefore, there is no degradation of the output voltage of sample 1 with respect to sample 2.

As to the porosity TiO2 film used for the photo-electrochemical cell of this invention, the porosity of the TiO2 film of the sample 1 is 48%.

As mentioned above, by this invention the photon conversion efficiency can be remarkably improved in the long wavelength range over 600nm without deterioration of the output voltage of the photo-electrochemical cell.

Example 2

The porous TiO2 film explained in the above-mentioned example has been used as a first layer of a 2-layer structure of the $TiO_2$ film of this example 2.

The same paste prepared in Example 1 is deposited on the first layer of Example 1 by doctor blade method, keeping the electrode warm at about 60°C. After drying up the obtained film, the film is sintered at 450°C for 20 minutes. The second layer of porous TiO2 film had 20-150 nm particle size distribution, 46 nm BET average particle size 30 m$^2$/g BET surface, 12 $\mu$m film thickness and 61% porosity. Using this 2-layer film, the photo-electrochemical cell was fabricated with the same electrolyte and by the same fabrication method of photo-electrochemical cell explained in the first example. However, for the adsorbing the dye on the TiO2 film, a 5·10$^{-4}$ M dry ethanol solution of tris-thiocyanato(4,4',4"-tricarboxy-2,2':6',2"-terpyridine)ruthenium (II) dye was used.

Fig 5 shows the comparison of photon conversion efficiency in the photo-electrochemical cells of the first and second examples. They show the photon conversion efficiency as a function of the wavelength for each sample. The sample 1 has the 2-layer TiO2 film explained in the second example and use the tris-thiocyanato(4,4',4" tricarboxy-2,2': 6',2"-terpyridine)ruthenium(II) dye. The sample 2 has the single layer TiO2 film (the first layer of the second example) of the first example and use the tris-thiocyanato(4,4',4"-tricarboxy-2,2':6',2"-terpyridine)ruthenium(II) dye. The sample 3 has the single layer TiO2 film (the first layer of second example) of the first example and use the cis-di(thiocyanato) bis(4,4'-dicarboxylate-2,2'-bipyridine)ruthenium(II) dye.

Samples with a single metal oxide layer of same high porosity (60 %) but with the wide range of distribution particle size, like those of samples 2 and 3 of examples 1 among others, displayed results of lesser photon conversion efficiency.

As clarified in Fig 5, the photo-electrochemical cell in which the 2-layer TiO2 film by this invention is applied to the photo-electrode shows remarkable high photon conversion efficiency, specially in the long wavelength range, at 600-1000nm.

Also, for the output voltage, the sample 1 based on the second example of this invention generates 0.68V under the photovoltaic standard condition of AirMass1.5, and 1000W/m2, which is approximately the same level output voltage of 0.67V generated by the system fabricated by the conventional technology. Therefore, there is no degradation of the output voltage by thickening of the $TiO_2$ film.

According to the above explanations, the photo conversion efficiency can be improved in the long wavelength range without degradation of the output voltage of the photo-electrochemical cell.

The photon conversion efficiency can be improved by the TiO2 film with the 2-layer structure in which the first layer closer to the anode substrate is the more dense layer and the second layer closer to the cathode electrode is the less dense layer. Concretely, the dye adsorption can be improved in the layer close to TCO (glass substrate) and the redox couple diffusion flow can be improved in the second layer close to cathode electrode ; therefore, the current in the photo-electrochemical cell will flow without any restraint of the ionic flow. In addition, the pores between the TiO2 particles of the less dense layer close to cathode electrode enhance the light scattering effect, in the same way as the bigger TiO2 particles produce light scattering. Also the problem of voltage decline due to the thickness of film can be solved.

**Claims**

1. A photo-electrochemical cell, comprising an anode electrode (20) having a film (23) of metal oxide semiconductor particles which have been deposited and sintered on a transparent substrate, a dye (25) that is adsorbed as a monomolecular layer on the surface of said metal oxide particles, a cathode electrode (10), and an electrolyte (30) that is filling the space between the said anode electrode and cathode electrode, **characterised in that** the said metal oxide particles comprise small size particles of sizes less than 30 nm and preferably higher than 10 nm and big size particles of sizes bigger than 100 nm and preferably smaller than 200 nm, and the average particle size of the particles is 30-50 nm.

2. A photo-electrochemical cell according to claim 1, **characterised in that** the particles of the said metal oxide are particles of TiO2.

3. A photo-electrochemical cell according to claim 1 or 2, **characterised in that** the BET surface area of said metal oxide particles layer is from 25 to 45 m$^2$/g.

4. A photo-electrochemical cell according to anyone of claims 1 to 3, **characterised in that** the distribution of particles sizes of said metal oxide particles is comprised in the range from 10 to 200 nm.

5. A photo-electrochemical cell according to claim 4, **characterised in that** the distribution of the particle size of said metal oxide particle is comprised in the range from 15 to 180nm.

6. A photo-electrochemical cell according to anyone of claims 1 to 5, wherein the weight proportion of said small size particles is at least 15 %, preferably at least 20 % and the weight proportion of said big size particles is at least 1 %, preferably at least 5 %.

7. A photo-electrochemical cell according to one of claims 1 to 6, wherein the porosity of the said metal oxide layer is from 45 to 55 %.

8. A photo-electrochemical cell according to anyone of claims 1 to 7, wherein the thickness of said metal oxide layer is from 10 to 25 $\mu$m.

9. A photo-electrochemical cell according to any one of claims 1 to 8, **characterised in that** said metal oxide film consists of two layers with the first layer, which is deposited directly on said anode electrode substrate, and the second layer, which is deposited directly on this first layer, the said second layer having a porosity higher than the said first layer and preferably the average metal oxide particles size similar to the said first layer.

10. A photo-electrochemical cell according to claim 9, **characterized in that** the porosity of said first layer is 45 - 55% and the porosity of said second layer is 55 - 65%.

11. A photo-electrochemical cell according to anyone of claims 8 to 10, **characterised in that** the thickness of said first layer is from 10 to 25 $\mu$m and the thickness of said second layer is from 5 to 20 $\mu$m.

12. A photo-electrochemical cell according to anyone of claims 1 to 10, wherein the electrolyte comprises the redox couple I$^-$/I$_2$ dissolved in an organic solvent preferably acetonitrile.

13. A photo-electrochemical cell according to anyone of claims 1 to 12 wherein the dye comprises a ruthenium complex with ligand comprising preferably carboxylate groups.

**Patentansprüche**

1. Photoelektrochemische Zelle, umfassend eine Anodenelektrode (20), die einen Film (23) aus Metalloxidhalbleiterpartikeln, die auf einem transparenten Substrat abgelagert und gesintert worden sind, einen Farbstoff (25), der als eine monomolekulare Schicht auf der Oberfläche der Metalloxidpartikel adsorbiert ist, eine Kathodenelektrode (10) und einen Elektrolyt (30), aufweist der den Hohlraum zwischen der Anodenelektrode und der Kathodenelektrode ausfüllt, **dadurch gekennzeichnet, daß** die Metalloxidpartikel Partikel kleiner Größe mit einer Größe kleiner als 30 nm und vorzugsweise mehr als 10 nm und Partikel großer Größe mit einer Größe größer als 100 nm und vorzugsweise kleiner als 200 nm umfassen, und daß die durchschnittliche Partikelgröße 30-50 nm beträgt.

2. Photoelektrochemische Zelle nach Anspruch 1, **dadurch gekennzeichnet, daß** die Partikel des Metalloxids TiO$_2$-Partikel sind.

3. Photoelektrochemische Zelle nach Anspruch 1 oder 2, **dadurch gekennzeichnet, daß** der BET-Oberflächenbereich der Metalloxidpartikelschicht 25 bis 45 m$^2$/g beträgt.

4. Photoelektrochemische Zelle nach einem der Ansprüche 1 bis 3, **dadurch gekennzeichnet, daß** die Verteilung der Partikelgrößen der Metalloxidpartikel in dem Bereich von 10 bis 200 nm liegt.

5. Photoelektrochemische Zelle nach Anspruch 4, **dadurch gekennzeichnet, daß** die Verteilung der Partikelgröße der Metalloxidpartikel in dem Bereich von 15 bis 180 nm liegt.

**6.** Photoelektrochemische Zelle nach einem der Ansprüche 1 bis 5, wobei der Gewichtsanteil der Partikel kleiner Größe wenigstens 15 %, vorzugsweise wenigstens 20% beträgt und der Gewichtsanteil der Partikel großer Größe wenigstens 1 %, vorzugsweise wenigstens 5 % beträgt.

**7.** Photoelektrochemische Zelle nach einem der Ansprüche 1 bis 6, wobei die Porosität der Metalloxidschicht 45 bis 55 % beträgt.

**8.** Photoelektrochemische Zelle nach einem der Ansprüche 1 bis 7, wobei die Dicke der Metalloxidschicht 10 bis 25 $\mu$m beträgt.

**9.** Photoelektrochemische Zelle nach einem der Ansprüche 1 bis 8, **dadurch gekennzeichnet, daß** der Metalloxidfilm aus zwei Schichten besteht, wobei die erste Schicht, direkt auf dem Anodenelektrodensubstrat abgelagert ist und die zweite Schicht, direkt auf dieser ersten Schicht abgelagert ist, wobei die zweite Schicht eine Porosität aufweist, die größer als die der ersten Schicht ist, und die durchschnittliche Metalloxidpartikelgröße vorzugsweise ähnlich der der ersten Schicht ist.

**10.** Photoelektrochemische Zelle nach Anspruch 9, **dadurch gekennzeichnet, daß** die Porosität der ersten Schicht 45 bis 55 % beträgt und die Porosität der zweiten Schicht 55 bis 65 % beträgt.

**11.** Photoelektrochemische Zelle nach einem der Ansprüche 8 bis 10, **dadurch gekennzeichnet, daß** die Dicke der ersten Schicht 10 bis 25 $\mu$m beträgt und die Dicke der zweiten Schicht 5 bis 20 $\mu$m beträgt.

**12.** Photoelektrochemische Zelle nach einem der Ansprüche 1 bis 10, wobei der Elektrolyt das Redoxpaar $I^-/I_2$ umfaßt, das in einem organischen Lösungsmittel, vorzugsweise Acetonitril gelöst ist.

**13.** Photoelektrochemische Zelle nach einem der Ansprüche 1 bis 12, wobei der Farbstoff einen Rutheniumkomplex mit Liganden umfaßt, die vorzugsweise Carboxylatgruppen umfassen.

**Revendications**

**1.** Une pile photo-électrochimique du type comprenant une anode (20) comprenant une couche (23) de particules d'oxyde métallique semi-conducteur déposées sur un substrat transparent et fritées, un colorant (25) adsorbé en tant que monocouche moléculaire sur la surface desdites particules d'oxyde métallique, une cathode (10), et un électrolyte (30) qui remplit l'espace entre lesdites anode et cathode, **caractérisée en ce que** lesdites particules d'oxyde métallique comprennent des particules de petite taille avec des tailles de moins de 30 nm et de préférence de plus de 10 nm, et des particules de grande taille avec des tailles de plus de 100 nm et de préférence de moins de 200 nm, et dont la taille moyenne des particules est de 30-50 nm.

**2.** Une pile photo-électrochimique selon la revendication 1 **caractérisée en ce que** les particules dudit oxyde métallique sont des particules de $TiO_2$.

**3.** Une pile photo-électrochimique selon la revendication 1 ou 2 **caractérisée en ce que** la surface BET de la couche des particules dudit oxyde métallique est comprise entre 25 et 45 $m^2$/g.

**4.** Une pile photo-électrochimique selon l'une des revendications 1 à 3, **caractérisée en ce que** la distribution des tailles de particule desdites particules d'oxyde métallique est comprise dans l'intervalle de 10 et 200 nm.

**5.** Une pile photo-électrochimique selon la revendication 4, **caractérisée en ce que** la distribution des tailles de particule desdites particules d'oxyde métallique est comprise dans l'intervalle de 15 à 180 nm.

**6.** Une pile photo-électrochimique selon l'une des revendications 1 à 5, **caractérisée en ce que** la proportion en poids desdites particules de petite taille est d'au moins 15%, de préférence d'au moins 20%, et la proportion en poids desdites particules de grande taille est d'au moins 1%, de préférence d'au moins 5%.

**7.** Une pile photo-électrochimique selon l'une des revendications 1 à 6, **caractérisée en ce que** la porosité de ladite couche d'oxyde métallique est de 45 à 55%.

**8.** Une pile photo-électrochimique selon l'une des revendications 1 à 7, **caractérisée en ce que** l'épaisseur de ladite couche d'oxyde métallique est de 10 à 25 $\mu$m.

**9.** Une pile photo-électrochimique selon l'une des revendications 1 à 8, **caractérisée en ce que** ladite couche d'oxyde métallique consiste en deux couches, avec une première couche déposée directement sur le substrat de ladite anode, et une deuxième couche, déposée directement sur cette première couche, ladite deuxième couche comprenant une porosité plus élevée que ladite première couche et une taille moyenne des particules d'oxyde métallique de préférence similaire à celle de ladite première couche.

**10.** Une pile photo-électrochimique selon la revendication 9, **caractérisée en ce que** la porosité de ladite première couche est de 45 - 55% et la porosité de ladite deuxième couche est de 55 - 65%.

**11.** Une pile photo-électrochimique selon l'une des revendications 8 à 10, **caractérisée en ce que** l'épaisseur de ladite première couche est de 10 à 25 $\mu$m et l'épaisseur de ladite deuxième couche est de 5 à 20 $\mu$m.

**12.** Une pile photo-électrochimique selon l'une des revendications 1 à 10, **caractérisée en ce que** l'électrolyte comprend le couple redox I$^-$/I$_2$ dissous dans un solvant organique de préférence l'acétonitrile.

**13.** Une pile photo-électrochimique selon l'une des revendications 1 à 12, **caractérisée en ce que** le colorant est constitué d'un complexe de ruthénium avec un ligand comprenant de préférence des groupes carboxylate.

Fig. 1

Fig. 2

Fig. 3

Fig. 4

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5084365 A

- EP 1089305 A

**Non-patent literature cited in the description**

- **ROTHENBERGER et al.** *Solar Energy Materials and Solar Cells,* 1999, vol. 58, 321-336

- *J.Am.Chem.Soc,* 1993, vol. 115, 6382-6390